# EUROPEAN PATENT SPECIFICATION

(11) **EP 1 717 001 B1**
(45) Date of publication and mention of the grant of the patent: **26.05.2010**
(21) Application number: 06008440.7
(22) Date of filing: 24.04.2006
(51) Int. Cl.: B28D 5/04

(54) **Method for manufacturing semiconductor wafers, method for their slicing and wire saw used for the same**
Verfahren zur Herstellung von Halbleitern, Verfahren um sie zu schneiden und Drahtsäge dafür
Méthode de fabrication de plaquettes semiconductrices, méthode pour leur coupe, et scie à fil pour sa mise en oeuvre

(30) Priority: 25.04.2005 JP 2005125989
(43) Date of publication of application: 02.11.2006
(73) Proprietor: Komatsu NTC Ltd., Shinagawa-ku Tokyo (JP); Disco Corporation, Tokyo 143-8580 (JP)
(72) Inventor: Miyata, Kensyo, Yokosuka-shi Kanagawa (JP); Harada, Seiji, Tokyo 143-8580 (JP); Nagasawa, Keiichi, Tokyo 143-8580 (JP)
(74) Representative: Grünecker, Kinkeldey, Stockmair & Schwanhäusser Anwaltssozietät

(56) References cited:
- EP-A- 0 754 785
- US-A- 6 006 738
- US-A- 6 112 738
- US-B1- 6 200 908
- PATENT ABSTRACTS OF JAPAN vol. 2003, no. 12, 5 December 2003 (2003-12-05) -& JP 2004 063883 A (TOSHIBA CERAMICS CO LTD), 26 February 2004 (2004-02-26)
- PATENT ABSTRACTS OF JAPAN vol. 2003, no. 12, 5 December 2003 (2003-12-05) -& JP 2003 318138 A (SUMITOMO MITSUBISHI SILICON CORP), 7 November 2003 (2003-11-07)

## Description

The present invention claims foreign priority to Japanese patent application no. P.2005-125989. filed on April 25, 2005.

The present invention relates to a method for manufacturing semiconductor wafers according to the preamble of claim 1, a slicing method for slicing a work according to the preamble of claim 4, and a wire saw according to the preamble of claim 5.

Such methods and such a wire saw are known from US 6,006,738 A.

US 6,006,738 A discloses a slicing method for slicing a work by using a wire saw. The wire saw comprises a wire, a releasing reel for releasing the wire, a winding reel for winding the wire, a pair of reel motors for rotating the releasing reel and the winding reel, a wire array formed by winding the wire among processing rollers, a spindle motor and a wire feeding control unit which controls the spindle motor and the pair of reel motors.

The slicing method comprises the steps of reciprocatingly feeding the wire, supplying slurry between the wire array and the work and pushing the work onto the wire array so as to slice the work into a plurality of wafers at one time.

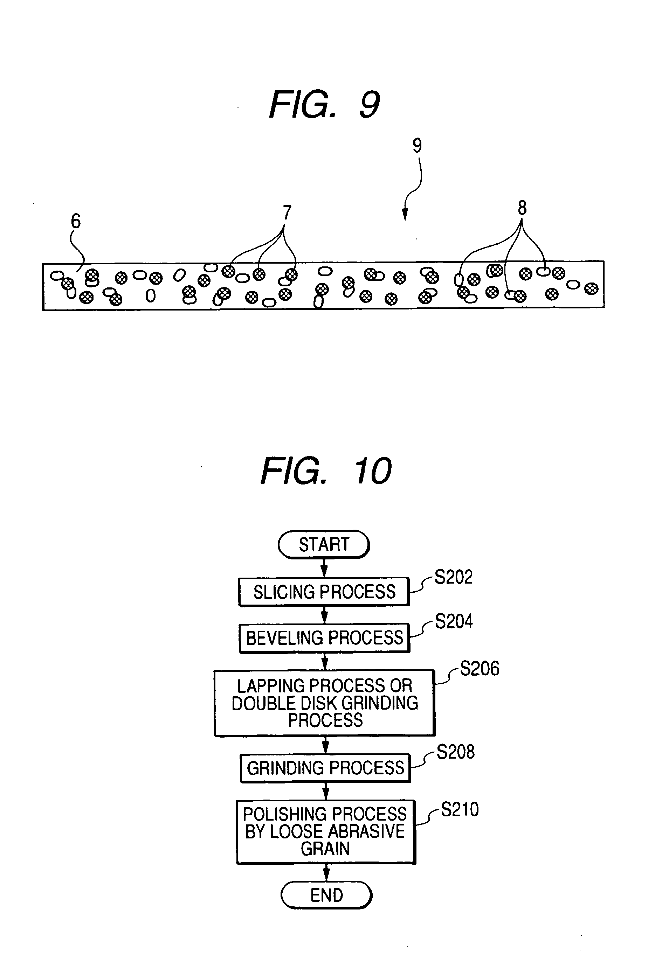

Conventionally, semiconductor wafers (hereinafter, called wafers) have been manufactured according to a manufacturing process shown in a flowchart of Fig. 10. As shown in Fig. 10, the first step S202 is a slicing process. That is, in step S202, an outer peripheral of a single crystal ingot, which is manufactured by, for example, a single crystal pulling method, is ground, and then, an orientation flat process, a notch process or the like is performed so as to determine a position of a crystalline orientation, after that, the single crystal ingot is sliced by an inner circumferential blade-type blade saw or a wire saw. Next, as a step S204, a beveling process is performed. In the step S204, an outer peripheral portion of the sliced wafer is beveled by a polishing wheel.

Step S206 is a lapping process or a double disk grinding process. In step S206, the wafer has a uniform thickness by the lapping process or the double disk grinding process and at the same time, waviness of the wafer caused by the slicing operation is removed.

Step S208 is a grinding process. In step S208, both sides of the wafer are separately or simultaneously ground by a grinding wheel such that both sides are flattened.

Step S210 is a polishing process. Both sides of the wafer are mirror-polished by using CMP (Chemical Mechanical Polishing) or the like.

Wafers have been manufactured according to the above-described processes. However, because there are a great number of processes, as described above, for manufacturing wafers from a single crystal ingot, the need for simplifying a wafer manufacturing process arises. In view of this, omission of the lapping process or the double disk grinding process has been taken into account.

However, a problem remains in that waviness of the wafer surface generated at slicing the single crystal ingot cannot be removed by only a general grinding process, thus, the lapping or double disk grinding process is required.

To solve the problem, in Japanese Patent Unexamined Publication No. JP 9097775, disclosed is a method by which a lapping process or a double disk grinding process is omitted and both sides of the wafer are polished at the same time by using an abrasive containing loose abrasive grains and a hard polishing cloth such that processing with high flatness can be performed, and at the same time, waviness of the wafer surface caused by the slicing operation is removed.

Moreover, in Japanese Patent Unexamined Publication No. JP2004063883, a lapping process or a double disk grinding process is omitted, after performing plasma-etching on a rear side of the wafer and removing waviness of the wafer surface caused by the slicing operation, the wafer surface is ground and, then the wafer surface is polished.

The present inventors studied the above-mentioned problems and found that waviness cannot be completely removed by the above-described solving means.

Conventionally, Waviness has been considered that one component constitute the waviness. However, in fact, it is proven that there is long period waviness, in which the wavelength is long, as well as short period waviness, in which the wavelength is short, and that the waviness is composed of combination of short period waviness and long period waviness. Further, it is revealed that the long period waviness is hard to be removed by a polishing process.

Note that, the long period waviness generally directs to a wavelength of 20 mm or more and the short period waviness generally directs to a wavelength of 10 mm or less.

The Short period waviness can be removed by using hard polishing cloth while maintaining flatness of the wafer. However, even though using the hard polishing cloth, long period waviness cannot be removed, because the surface of the polishing cloth follows the long period waviness due to the gentle rise and fall of the long period waviness.

Further, as for short period waviness, in the case of Chemical Mechanical Polishing of the JP-A-9-97775 in which polishing is performer by a polishing cloth using an abrasive containing loose abrasive grains, there is a problem of difficulty of removing even the short period waviness, because the polishing cloth has its a maximum limit in term of hardness.

Aside from the foregoing problems, recently, diameter of a wafer has been made the transition from 203,2mm (8 inches) (hereinafter, called 8") to 304,8mm (12 inches) (hereinafter called 12"). For Example, the change in size of a DRAM has made from 256MB (megabyte) to 1GB (gigabyte) and micro-fabrication and high integration are commonly performed more and more. An increase in size of the semiconductor wafers in response to such needs allows a considerable reduction in cost. On the other hand, strict form accuracy for processing accurate and quality semiconductor wafers are required. A conventional form accuracy of high flatness concerns deviation in thickness of an entire surface of a wafer, referred as TTV (Total Thickness Variation). But new form accuracy of high flatness is evaluated according to site flatness SFQR (Site, Front surface, site least sQuares, Range) and this value is currently becoming strict.

In addition, a very small amount of long period waviness (nanotopology), which has been ignored, becomes a problem from a 300 mm (12") size wafer. To remove this very small amount of the long period waviness becomes a new bottleneck technique.

The present invention is devised in view of these problems, and it is an object of the present invention to provide a method for manufacturing semiconductor wafers by which slicing is performed without generating long period waviness on the surface of a wafer by a slicing process using a wire saw and at the same time, short period waviness remaining in the surface of the sliced wafer is completely removed by a polishing process, such that a lapping process or a double disk grinding process is omitted.

The present inventors have thought that at first, long period waviness cannot be removed without a wire saw. Therefore, the inventors have taken into account of improving the wire saw so as not to generate waviness on a wafer surface by the slicing operation of the wire saw. Up to now, for example, like Japanese Patent Unexamined Publication No. JP 11058210, a slicing method has been provided in which a feed amount of a work or a supply of the slurry is adjusted, or a feed amount of a work per one cycle of the feeding and returning of the wire is changed during a predetermined time between the start and end of the slicing operation of the work in order to reduce the unevenness of the thickness and the warp of the wafer. Also, like Japanese Patent Unexamined Publication No. JP-A-2000-141201, provided is a slicing method by which a new wire supply quantity or the cycle number or a cycle period is controlled according to a length of a chord of a sliced surface of a work so as to reduce the waviness of the sliced surface or prevent surface roughness.

However, in the methods, because all waviness and the unevenness in thickness are removed by the wire saw, it may be impossible to remove the important long period waviness.

In the present invention, because only long period waviness is planned to removed in a slicing process by a wire saw, the present inventors have paid close attention to the number of cycles of reciprocating travel of a wire and comes up with a method of changing the waviness that is occurring as long period waviness into short period waviness by increasing the number of cycles.

Conventionally, in the present wire saw, the number of cycles of reciprocating travel of the wire is generally 1 to 2 per a minute. However, the inventor of the present invention found that in the case of 3 or more cycles per minute when a work is sliced by the wire saw, waviness occurring as long period waviness generated in the conventional method can be changed into short period waviness according to the theory.

According to this theory, it applies to all of the cases where ever the case of 3 or more cycles. However, in the case of 8 or more cycles, even though short period waviness can be removed, because there is a problem in the follow-up capability of control and servo systems if remaining high-speed feeding such as performed conventionally, to make 8 or more cycles becomes an impossible case when considering a mechanical construction of the wire saw. Therefore, the inventor set the upper limit being less than 8 cycles per a minute.

AS for this, it is possible to remove waviness in a slicing method, disclosed in Japanese Patent Unexamined Publication No.JP-A-2003-318138, in which a wire is reciprocated in multiple cycles of 8 or more, but is not a realistic method in the case of 8 or more cycles. Moreover, the JP-A-2003-318138 is not focused at removing only long period waviness and therefore is essentially different from the present invention.

For the above reasons, when a work is sliced by a wire saw, short period waviness as well as long period waviness is reduced while the work is sliced by reciprocating the wire at the predetermined constant number of cycles of 3 or more and less than 8 per a minute.

This is because short period waviness, which is occurred in the conventional method, is changed into short period waviness in the present invention, as a result, into ultra-short period waviness up to a level in which the waviness is not observed as waviness.

However, it may be impossible to change all kinds of the waviness into short period waviness within cycles of 3 or more and less than 8 per a minute. Therefore, short period waviness needs to be removed separately. Short period waviness can be removed by a lapping process or a double disk grinding process. However, because an object is to remove these processes, it is preferable that waviness is removed together with the polish processing according to the conventional polishing process when the processes are omitted.

Even though removing waviness in a grinding process can be also considered, it is impossible to remove the waviness because waviness opposite to a processed surface is transcribed and processed when grinding is performed on a chuck table. In addition, it may be impossible to remove waviness during the grinding operation without using a special technique.

Accordingly, waviness has to be removed during the polishing process. However, there is a limit to hardness of the polishing cloth used in a general CMP (chemical mechanical polishing) in which polishing is performed by using the polishing cloth in combination with the loose abrasive grains. In short, if hardness is high, polishing may be impossible because the loose abrasive grains do not remain in the polishing cloth but separate therefrom.

Therefore, even though polishing cloth needs to be soft to some extent, softness causes the polishing cloth to be warped the by short period waviness. As a result, polishing can be performed by the soft polishing cloth but it is hard to remove waviness.

Accordingly, the present inventors can completely remove short period waviness remaining on the wafer surface by polishing the surface of the work by using a fixed abrasive grain polishing cloth.

There is provided a method for manufacturingsemiconductor wafers, comprising the steps of:
a slicing process for slicing a work by using a wire saw comprising a wire array formed by winding a wire multiple times around a plurality of processing rollers, the slicing process comprising the steps of:
   reciprocatingly feeding the wire at predetermined constant cycles of 3 or more and less than 8 per a minute, the one reciprocation of the wire is determined as one cycle;
   supplying slurry between the wire array and the work; and
   pushing the work onto the wire array so as to slice the work into a plurality of wafers at one time,
   According to the present invention, the wire is fed such that a returning length, of which length is defined during returning the wire, is shorter than a going length, of which length is defined during feeding the wire, there is provided
a grinding process of grinding both sides of the sliced wafer by a grinding wheel, one-side by one-side;
a polishing process of performing a chemical mechanical polishing on both sides of the ground wafer by a fixed abrasive grain polishing cloth, in which an abrasive grain is fixed, and a abrasive containing no abrasive grains.

According to a preferred embodiment, the manufacturing method may further comprise the steps of:
an etching process of removing a deformed layer of the wafer generated by the grinding process;
a mirror beveling process of finishing an outer peripheral edge of the wafer as a mirror; and
a single side finish polishing process of finishing one side of the wafer as a mirror after the polishing process.

According to another preferred embodiment,
the fixed abrasive grain polishing cloth may be a polyurethane polishing pad comprising:
a polyfunctional isocyanate;
a polyfunctional polyol having an average molecular weight of 250 or more and 4,000 or less;
a foaming agent for setting an expansion ratio of the polishing pad as 1.11 to 5 times; and
abrasive grains having an average diameter of 0.15 µm or more and 50 µm or less in a range of 5 vol.% or more and 70 vol.% or less,
wherein the abrasive grains are mixed with the stirred mixture of the polyfunctional isocyanate, polyfunctional polyol and foaming agent.

furthermore, there is provided a slicing method for slicing a work by using a wire saw comprising a wire array formed by winding a wire multiple times around a plurality of processing rollers, the slicing method comprising the steps of:
reciprocatingly feeding the wire at predetermined constant cycles of 3 or more and less than 8 per a minute, the one reciprocation of the wire being determined as one cycle;
supplying slurry between the wire array and the work; and
pushing the work onto the wire array so as to slice the work into a plurality of wafers at one time, according to the present invention,
the wire is fed such that a returning length, of which length is defined during returning the wire, is shorter than a going length, of which length is defined during feeding the wire.

According to the invention, there is provided a wire saw as defined by claim 5.

The benefits of the present invention as defined by the claims, are that a lapping process or a double disk grinding process is omitted and long period waviness is removed by slicing a work by reciprocating a wire in a predetermined constant number of cycles of 3 or more and less than 8 per a minute, when the work is sliced by a wire saw. In addition, short period waviness remaining on the surface of the sliced wafer is removed by fixed abrasive grain polishing cloth and polishing liquid (alkaline liquid), which does not contain abrasive grains, such that waviness can be completely removed from the surface of the semiconductor wafer. Accordingly, the semiconductor wafer can be manufactured without the lapping process or the double disk grinding process.

### BRIEF DESCRIPTION OF THE DRAWINGS

Fig. 1 is a perspective view showing a main part of a wire saw according to the present invention;
Fig. 2A is a cycle diagram showing a change in wire speed with respect to time when a work is sliced according to a conventional example;
Fig. 2B is a cycle diagram showing a change in wire speed with respect to time when a work is sliced according to an example of the present invention;
Fig. 2C is a cycle diagram showing a change in wire speed with respect to time when a work is sliced according to another example of the present invention:
Fig. 3 is a flowchart illustrating a method of manufacturing semiconductor wafers according to a first embodiment of the present invention;
Fig. 4A is a graph showing short period waviness appeared in the surface of the 304,8mm (12") wafer;
Fig. 4B is a graph showing long period waviness appeared in the surface of the 304,8mm(12") wafer,
Fig. 5A is a plane view showing a state, captured after the finish grinding operation while long period waviness and short period waviness remain on the wafer surface when the wafer is sliced according to conventional 1 to 2 cycles of reciprocating travel of the wire;
Fig. 5B is a plane view showing a state, captured after polishing further in addition to the finish grinding operation while long period waviness remains on the wafer surface when the wafer is sliced according to conventional 1 to 2 cycles of reciprocating travel of the wire;
Fig. 6A is a plane view showing a state, captured after the finish polishing operation, in which only short period waviness remains on the wafer surface when the wafer is sliced according to wire reciprocation of 3 cycles in accordance with a method of the present invention;
Fig. 6B is a plane view showing a state, captured after polishing further in addition to the finish polishing operation, in which only short period waviness remains on the wafer surface when the wafer is sliced according to wire reciprocation of 3 cycles in accordance with a method of the present invention;
Fig. 7A is an enlarged sectional view of beginning stage of a conventional polishing method by which a polishing pad made of an unwoven fabric and slurry (polishing liquid) containing loose abrasive grains;
Fig. 7B is an enlarged sectional view of final stage of a conventional polishing method by which a polishing pad made of an unwoven fabric and slurry (polishing liquid) containing loose abrasive grains;
Fig. 8A is an enlarged sectional view of beginning stage of a polishing method of using fixed abrasive grain polishing cloth, which corresponds to the process S6;
Fig. 8B is an enlarged sectional view of intermediate stage of a polishing method of using fixed abrasive grain polishing cloth, which corresponds to the process S6,
Fig. 8C is an enlarged sectional view of final stage of a polishing method of using fixed abrasive grain polishing cloth, which corresponds to the process S6;
Fig. 9 is an enlarged sectional view showing one example of fixed abrasive grain polishing cloth;
Fig. 10 is a flowchart illustrating a conventional manufacturing method for semiconductor wafers;
Fig. 11 is an overall perspective view showing a double-side polishing apparatus; and
Fig. 12 is a longitudinal sectional view of the double-side polishing apparatus.

An embodiment of the present invention will be described in detail with reference to the accompanying drawings.

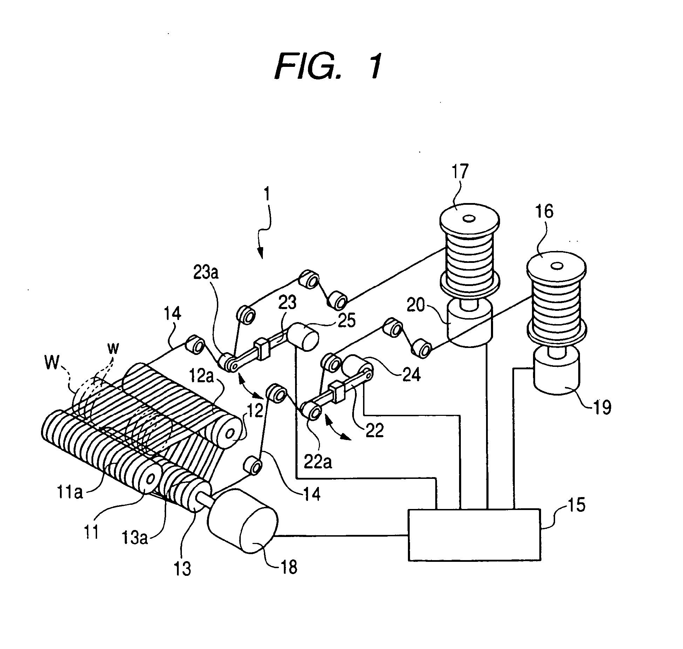

After a detailed study and many experiments, inventors confirmed that in a wire saw as shown in Fig. 1, long period waviness on a wafer surface disappears after slicing a work by reciprocating a wire of 3 or more and less than 8 reciprocations per a minute. First, the wire saw will be described.

Fig. 1 is a perspective view illustrating a main part of the wire saw. As shown in Fig. 1, the wire saw 1 includes three processing rollers 11, 12 and 13 disposed at predetermined intervals thereamong. A plurality of annular grooves are formed at outer peripherals of the respective processing rollers 11, 12 and 13 with predetermined pitches. Also, one wire 14 has both ends wound around a pair of reels 16 and 17, respectively. In addition, between both reels 16 and 17, the wire 14 is wound continuously around the annular grooves 11a, 12a and 13a of the respective processing rollers 11, 12 and 13.

A wire feeding unit includes a spindle motor 18 for traveling the wire connected to the processing roller 13 and reel motors 19 and 20 connected to a pair of reels 16 and 17. By the rotation of the motors 18, 19 and 20, the wire 14 is fed by the forward feeding of the processing rollers 11, 12 and 13 by a predetermined amount of feeding, and then, the wire 14 is returned by the reverse feeding of the processing rollers 11, 12 and 13 with a smaller amount of feed than the feed amount at forward feeding. By repetitively performing such the forward feeding and the reverse feeding as one feeding cycle, the wire 14 advances toward the forward side. While traveling the wire 14 in this state, a work W is pushed on the wire 14 between the processing rollers 11 and 12 such that the work W is sliced into a wafer shape so as to form a predetermined thickness.

A cutting blade of the wire saw 1 is abrasive grains mixed in slurry that is supplied to the wire 14 and slowly cuts off the work W according to the lapping operation by the abrasive grains rubbed against the wire 14.

Note that, the wire 14 is made of a steel wire, but may be made of a piano wire.

Dancer arms 22 and 23 are provided in a traveling course of the wire 14 between a pair of reels 16 and 17 and the processing rollers 11, 12 and 13. The wire 14 hangs on dancer rollers 22a and 23a that are disposed on front ends of the dancer arms 22 and 23. When tension is changed during the a course of traveling of the wire 14, the dancer arms 22 and 23 are rotated. In accordance with the rotation amount, detection signals of the change in wire tension are outputted from encoders 24 and 25.

The dancer arms 22 and 23 have dancer rollers 22a and 23a functioning as weights, and the dancer rollers 22a and 23a applies predetermined tension against the wire 14.

Further, a control device 15 including a wire feeding control unit controls the rotating numbers of the spindle motor 18 and a pair of reel motors 19 and 20 on the basis of set values for feeding a wire, such as the maximum wire feeding speed, supply of a new wire, and the number of cycles of reciprocating travel depending upon a type and material of a work. Moreover, the control device 15 performs feedback-control on the reel motor 19 and 20 in accordance with detection signals from the encoders 24 and 25.

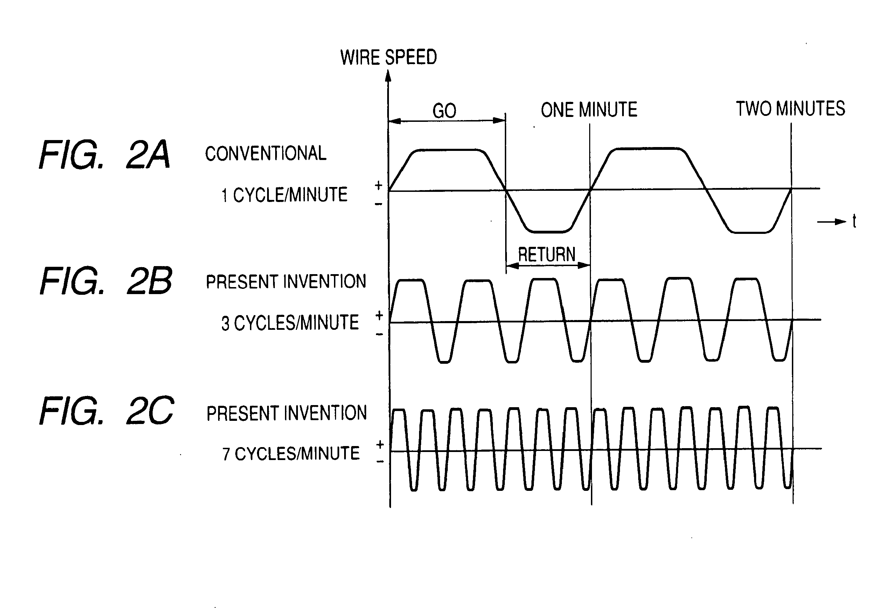

Figs. 2A, 2B and 2C are cycle diagrams showing a change in wire speed with respect to the time when a work is sliced. Fig. 2A is a cycle diagram illustrating an example in the related art, and Figs. 2B and 2C are cycle diagrams illustrating an example of the present invention. As shown in Fig. 2A, wire speed in the related art is one cycle per a minute and 2 cycles at the most.

In Fig. 2B, the wire speed is 3 cycles per a minute. In Fig. 2C, the wire speed is 7 cycles per a minute.

This waveform (cycle pattern) may be a curve, and the length of part at a predetermined speed of upper and lower ends showing the maximum feeding speed may be appropriately set and changed.

Accordingly, a method of slicing the work W of the present invention is performed by the control device 15 including the wire feeding control unit shown in Fig. 1. In the wire saw 1 which slices the work W into plurality of pieces by relatively pushing the work W on an wire array, when one reciprocation for reciprocating travel of the wire 14 is determined as one cycle, generation of long period waviness can be prevented if the work W is sliced while the wire 14 reciprocates according to predetermined constant cycles of 3 or more and less than 8 per a minute. As a result, the burden of performing subsequent grinding and polishing processes can be relieved and also high quality wafers (w) can be manufactured.

In particular, the generation of waviness can be considerably prevented under stable slicing operation without generating errors by reciprocating the wire 14 at the predetermined constant number of cycles of 4 or more and 6 or less per a minute when the work is sliced.

Further, the same cycle pattern may be repeated to an end of the process with respect to the same work at the maximum traveling speed of the wire 14 of 600 to 1500 m/min in one cycle for one reciprocation for reciprocating travel of the wire.

In this case, a high capacity motor of which output capacity is 45 to 110 kW is used as the spindle motor 18 in Fig. 1, thereby the high speed feeding of the wire 14 and feeding with the high number of cycles can be achieved.

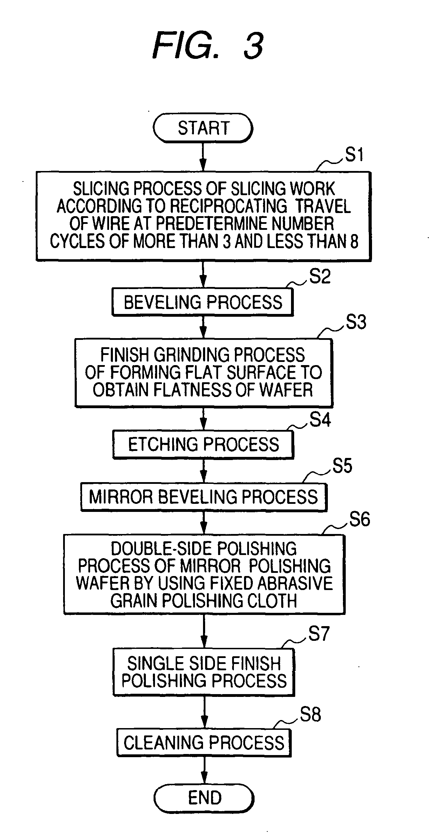

Fig. 3 is a flowchart showing a manufacturing method of semiconductor wafers according to an embodiment of the present invention, As shown in Fig. 3, a method of manufacturing semiconductor wafers in accordance with the present invention includes a slicing process (S1), in which the wire 14 is wound multiple times around a plurality of processing rollers to form an wire array, slurry is supplied between the wire array and the work W, while reciprocating the wire 14 such that a returning length is shorter than a going length, the work W is relatively pushed on the wire array and sliced into a plurality of wafers w, a beveling process (S2) in which an outer peripheral of the wafer w is beveled, a grinding process (S3) in which both sides of the wafer w are ground, an etching process (S4), a mirror beveling process (S5) in which an outer peripheral of the semiconductor wafer is beveled to a mirror finish, a first polishing process (S6) in which both sides of the wafer w are polished by using fixed abrasive grain polishing cloth 9, a single side finish polishing process (S7) in which one side is polished to a mirror finish, and finally a cleaning process (58) in which cleaning is performed, so that semiconductor wafers are manufactured. Hereinafter, the processes will be described in detail in order.

A silicon ingot is manufactured as a cylindrical ingot of 304,8mm (12") or more by pulling up a seed (a small piece of a silicon single crystal) from a melt silicon while rotating a quarts crucible (a CZ method). Thereafter, both ends are cut off and an outer peripheral of the silicon ingot is processed with a predetermined diameter. The process S1 is a process of slicing the silicon ingot (hereinafter, called a work W), in which the work W is sliced into 12" wafers w having a thickness of about 0.90 mm (900µm). Therefore, in the process S1 of the present invention, the work is sliced while the wire reciprocates at the predetermined constant number of cycles of 3 or more and less than 8 per a minute, when one reciprocating travel of reciprocating travel of the wire is determined as one cycle in the slicing process.

In addition, in the slicing process, it is suitable to reciprocate the wire 14 at the predetermined constant number of cycles between 4 and 6 per a minute.

Further, in the slicing process, 600 to 1500 m/min is suitable for the maximum traveling speed of the wire for one cycle of reciprocating travel of the wire 14. During the slicing operation, it is preferable that the same cycle pattern is repeated with respect to the same work W.

In the process S2, a process of beveling the wafer w is performed. An outer circumferential portion of the wafer w is beveled in a predetermined shape by metal beveling wheels of #600 and #1500 so as to form a predetermined round shape.

The process S3 is a finish grinding process and the wafer is ground. In this process, grinding operation is enough for only forming a flat surface of the wafer in order to obtain desired flatness. Both sides, of the wafer are mechanically ground by a grinding wheel having fine grain. Here, the total grinding amount of grinding both sides of the wafer w is about 60µm. Specifically, both sides are individually ground by a grinding device having a #2000 resinoid grinding wheel one-side by one-side.

In the grinding process, a face and the back face of the wafer are individually polished in order. Though it is ,not illustrated in the drawing, the polishing method is performed by an apparatus comprising, a rotary shaft having a chuck unit for holding wafers and, a grinding wheel facing the rotary shaft and mounted on one end of the rotary shaft. The grinding wheel grinds a face and the other face of the wafer by pushing the faces to the ground surface of the wafer by rotating the grinding wheel at a high speed. The grinding wheel used here is preferable to use grain diameter of the abrasive of #1500 or more so that a deformed layer generated by this process is as shallow as possible in order to reduce polishing amount in a first polishing process which is performed subsequently, and also there is required ultra high flatness.

In the process S4, etching is performed in order to remove distortion generated in the finish grinding process. A KOH (kalium hydroxide) solution of high concentration is suitable for an alkaline etching solution. Etching temperature is 90°C and etching time is six minutes. Here, a total etching amount of both a side and the other side of the wafer is 10 to 15 µm.

The process S5 is a polishing corner rounding (PCR) process in which part to be beveled is mirror-polished. According to the polishing corner rounding process, an outer peripheral of the wafer w is ground to a mirror finish. Accordingly, strength of the wafer w is improved and particle generation is prevented, such that deterioration in yield can be prevented.

The process S6, prior to the next process S7, is a double-side polishing process by which both sides of the wafer w are polished into mirror-surfaces by using the fixed abrasive grain polishing cloth 9 in which the abrasive grains are fixed. As for a degree of finishing here, both sides are finished to a finishing degree of the rear surface, and a demand for strict form accuracy SFQR of ultra-flatness of the surface is satisfied.

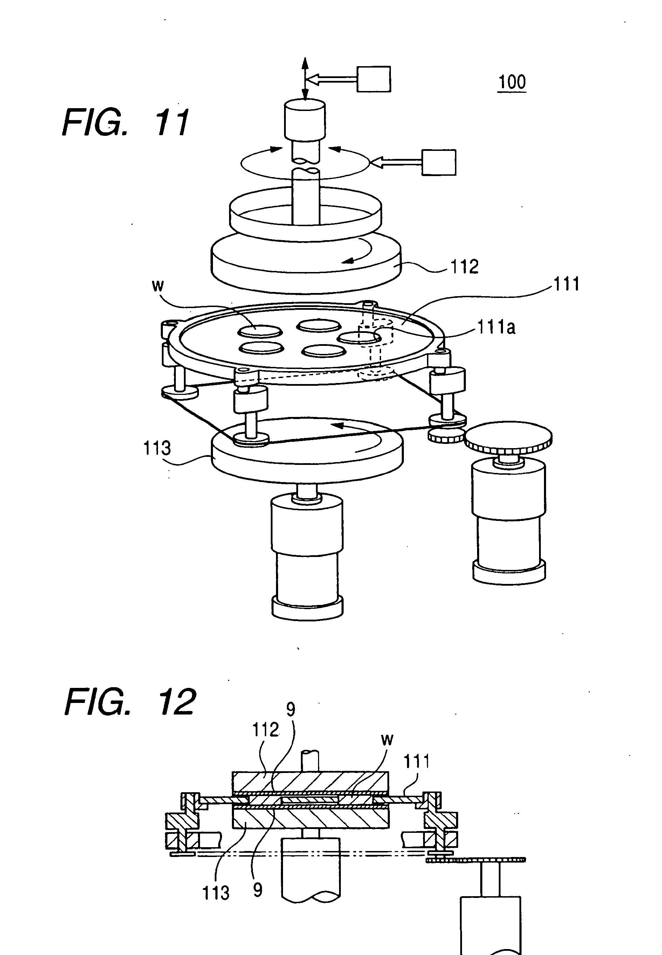

Fig. 11 is an overall perspective view illustrating a double-side polishing apparatus, and Fig. 12 is a longitudinal sectional view thereof. In this double-side polishing process, a double-side polishing apparatus 100 is used as shown in Figs. 11 and 12. The double-side polishing apparatus 100 includes a glass epoxy carrier plate 111 of a disc shape viewed in a plane, On the carrier plate 111, five wafer holding holes 111a is formed with intervals of 72 degrees around an axis (in a circumferential direction) of the plate. The double-side polishing apparatus 100 further includes an upper lapping plate 112 and a lower lapping plate 113 into which the 12" wafer w (300 mm in diameter) is vertically and rotatably inserted. The upper and lower lapping plates 112 and 113 move relative to the wafer w so as to polish a wafer surface.

The fixed abrasive grain polishing cloth 9 is a polyurethane polishing pad formed by mixing a polyfunctional isocyanate, a polyfunctional polyol having an average molecular weight of 250 to 4,000 and a foaming agent which allows a form expansion ratio of the polishing pad being 1.11 to 5 times and further, by mixing abrasive grains having an average grain diameter of 0.15 to 50 µm in the range of 5 to 70 vol.% with respect to the total of the polyurethane polishing pad.

In the process S7, the surface of one side of the wafer w is polished to a mirror finish (mirror polished) by using finish polishing cloth such as suede after the preceding process S5.

In the process S8, the process of cleaning the wafer w is performed. Specifically, the wafer w is cleaned by RCA (ammonia hydrogen peroxide)-based cleaning liquid.

Accordingly, a lapping or double disk grinding process in the related art is omitted after the slicing process by the wire saw. For the subsequent processes, it is enough for remaining machining allowance by which a flat surface is formed so as to obtain flatness (hereinafter, called TTV) within specifications. In addition, by easily removing short period waviness in the finish polishing process, the semiconductor wafers manufacturing process can be shortened.

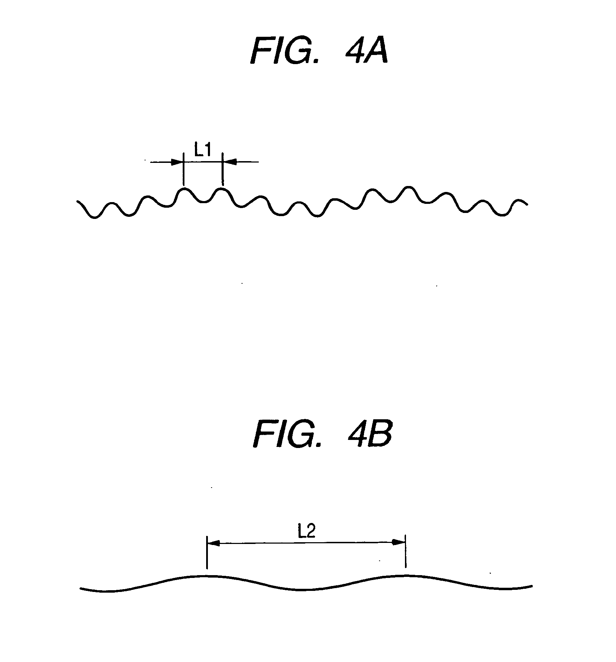

Figs. 4A and 4B show waviness occurring on the 304,8mm (12") wafer surface. Fig. 4A is a graph showing waviness composed of short period and long period and Fig. 4B is a graph showing long period waviness. As shown in Fig. 4A, a wavelength (L1) of short period waviness is about 8 mm, and it can be known that the wavelength (L1) gets on long period waviness shown in Fig. 4B. The long period waviness has a wavelength L2 of about 40 mm, as shown in Fig. 4B. Even though the short period waviness can be removed, it is difficult to remove the long waviness. The remained long period waviness is difficult to remove by a finishing process.

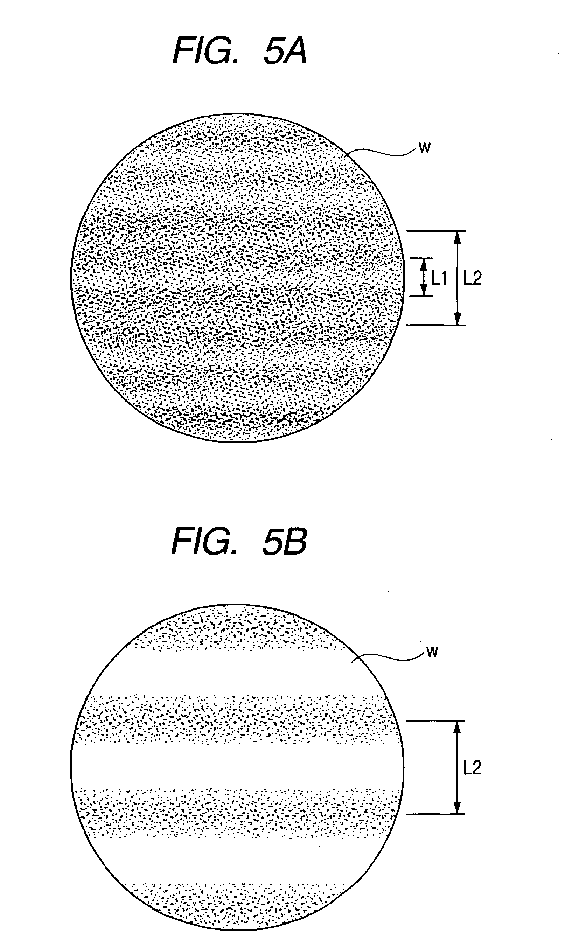

Figs. 5A and 5B show a surface state of a 304,8mm (12") wafer when the wafer is sliced according to 1 to 2 cycles of reciprocating travel of the wire as the related art. Fig. 5A is a plane view illustrating a state, captured after the finish polishing operation, in which long period waviness and short period waviness remain. Fig. 5B is a plane view illustrating a state, captured after further performing polishing, in which long period waviness remains.

As shown in Fig. 5A, in the method of slicing a work in the related art, it cannot avoid generation of long period waviness and the work is sliced into wafers w having long period waviness and short period waviness. In addition, as shown in Fig. 5B, long period waviness which has not become a problem was checked on the surface of the wafer after the polishing operation. However, nowadays the long period waviness becomes problem, as described heretofore.

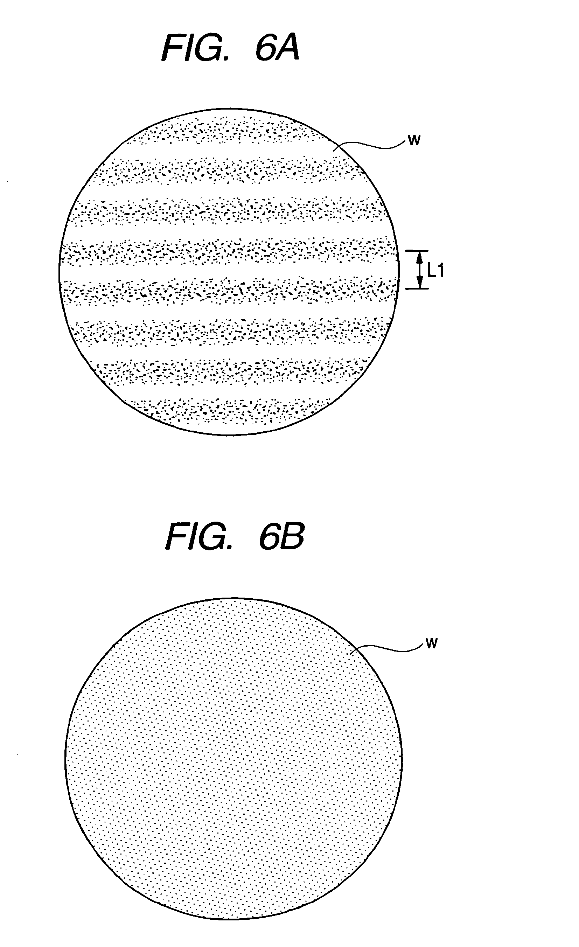

Figs. 6A and 6B show a state of the wafer surface when the wafer is sliced according to 3 cycles of reciprocating travel of the wire of the present invention. Fig. 6A is a plane view illustrating a state, captured after finish polishing operation, in which only short period waviness remains. Fig. 6B is a plane view showing a surface state captured after performing further polishing.

As shown in Fig. 6A, in the method of slicing a work in accordance with the present invention, short period waviness is found on the surface of the sliced wafer but long period waviness does not occur. In proof of this, as shown in Fig. 6B, after short period waviness is removed by the polishing process, high quality wafers free of long period waviness are completed. In the slicing experiments according to 4, 5, 6 and 7 cycles, like the 3 cycles, long period waviness was not found on the surface of the wafer w. Now, at this transitioning time shifting from 203,2mm (8") wafer to 304,8mm (12") or more wafer, this slicing method of the present invention becomes a significant technique in manufacturing high quality semiconductor wafers of 304,8mm (12") or more.

According to the experiments, first, as for short period waviness, in a slicing process by a wire saw, slicing operation is performer at predetermined constant number of cycles of 3, 4, 5, 6 and 7 per a minute for reciprocating travel of the wire. Grinding operation is performed to form a flat surface capable of satisfying the TTV. After the etching process, polishing process is performed according to a polishing method by using fixed abrasive grain polishing cloth of a polyurethane polishing pad (specifically, a polishing pad disclosed in JP-A-2006-257905). As a result, short period waviness is completely removed from the wafer surface.

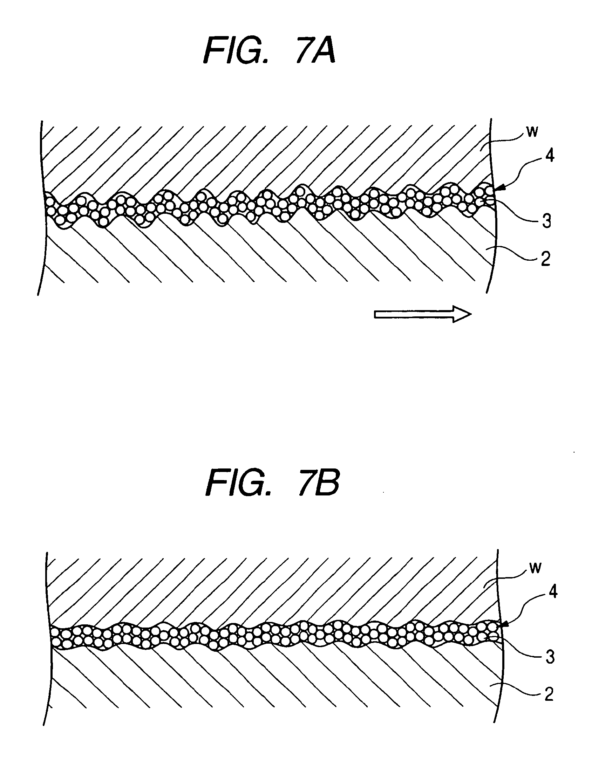

Figs. 7A and 7B illustrate a conventional polishing method using a polishing pad made of a unwoven fabric and slurry (polishing liquid) containing loose abrasive grains. Fig. 7A is an enlarged sectional view of a beginning stage, and Fig. 7B is an enlarged sectional view of a final stage. As shown in Fig. 7A, in the polishing method, the slurry 4 containing loose abrasive grains is supplied onto the polishing cloth 2 made of the unwoven fabric, thereby polishing a wafer w through the slurry 4.

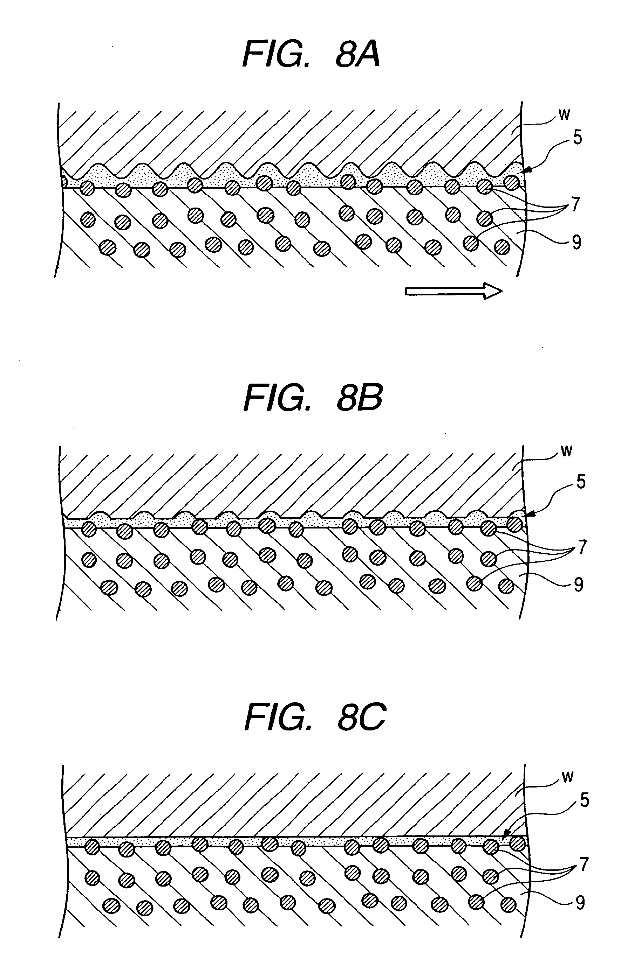

Figs. 8A, 8B and 8C illustrate a polishing method using fixed abrasive grain polishing cloth, which corresponds to the process S6. Fig. 8A is an enlarged sectional view of an early stage, Fig. 8B is an enlarged sectional view of an intermediate stage, and Fig. 8C is an enlarged sectional view of a final stage.

Fig. 9 is an enlarged sectional view showing one example of fixed abrasive grain polishing cloth.

As shown in Fig. 9, the fixed abrasive grain polishing cloth 9 is hard polyurethane resin 6. There are no loose abrasive grains 3, 3 ··· and all of the abrasive grains are fixed to the polyurethane resin 6. Fixed abrasive grains 7, 7 ··· are mixed into the polyurethane resin 6, and an appropriate amount of bubbles 8, 8··· are also formed therein. The fixed abrasive grain polishing cloth 9 of the polyurethane polishing pad is made such tha t a polyfunctional Isocyanate, a polyfunctional polyol having an average molecular weight of 250 to 4,000, and a foaming agent having an expansion ratio of the polishing pad of 1.11 to 5 times are mixed up, and abrasive grains having an average diameter of 0.15 to 50 µm in the range of 5 to 70 vol.% is added thereto. The polishing process is performed by using thus obtained fixed abrasive grain polishing cloth 9 with flowing alkaline liquid.

When the wafer w having short period waviness remains thereon is polished by the conventional polishing method as shown in Fig. 6A, because hardness of the polishing cloth of a unwoven fabric 2 is soft, such as a Shore D hardness of 5 to 20, the polishing cloth 2 is deformed along the surface waviness of the work W even though polishing operation is performed by using the loose abrasive grains 3. Therefore, as shown in Fig. 7B, because the waviness is not easily removed, short period waviness remains.

On contrary, because the fixed abrasive grain polishing cloth 9 of the polyurethane polishing pad, shown in Figs. 8A, 8B and 8C of the present invention, is as hard as a Shore D hardness of 40 to 80, the surface of the fixed abrasive grain polishing cloth 9 is not deformed and therefore polishing operation is allowed linearly. Accordingly, as shown in Fig. 8C, short period waviness can be easily removed, and as shown in Fig. 6B, waviness can be removed in a short time.

When one reciprocation for reciprocating travel of the wire is determined as one cycle, as a work W is sliced at the predetermined constant number of cycles of 3 or more and less than 8 per a minute, for example, when the work is sliced while the wire 14 travels at 7 cycles as shown in Fig. 2C with using conventional spindle motor, it was impossible to correspond to high speed feeding and feeding with the high number of cycles of the wire, because there has been a considerable problem in follow-up capability of the conventional spindle motor has output capacity of about 22 kW. However, by applying a spindle motor having output capacity of 45 to 80 kW, follow-up capability of control by a high servo power is considerably improved such that stable and accurate processing can be maintained. In addition, by determining output capacity of reel motors 19 and 20 at 30 to 45 kW, follow-up capability of control for reel rotation is improved.

Moreover, it is understood that various changes may be made without departing from the spirit and scope of the invention. For example, the order of the processes may be changed into another order. In addition, the beveling process S2 may be omitted and may include the polishing corner rounding process S5. Also, as for feeding speed of wire of the wire saw, it is possible to appropriately set the maximum speed or acceleration/deceleration according to processing, and the cycle pattern of various shapes is allowed. Furthermore, there may be one or more spindle motors 18 and it is preferable that the total output of the motors is set 45 kW or more.

In addition, it is possible to freely control work feed according to the work shape, adjust the amount of slurry fed into the wire or the like. Also, the work may be formed of germanium, gallium arsenic, sapphire or the like in addition to silicon.

While there has been described in connection with the preferred embodiments of the present invention, it will be obvious to those skilled in the art that various changes and modification may be made therein without departing from the present inventionas defined in the appended claim.

## Claims

1. A method for manufacturing semiconductor wafers, comprising the steps of:
a slicing process (S1) for slicing a work (W) by using a wire saw (1) comprising a wire array formed by winding a wire (14) multiple times around a plurality of processing rollers (11,12,13), the slicing process comprising the steps of:
reciprocatingly feeding the wire (14) at predetermined constant cycles of 3 or more and less than 8 per minute, the one reciprocation of the wire (14) is determined as one cycle;
supplying slurry between the wire array and the work (W); and
pushing the work (W) onto the wire array so as to slice the work (W) into a plurality of wafers (w) at one time, **characterized by**
the wire (14) being fed such that a returning length, of which length is defined during returning the wire (14), is shorter than a going length, of which length is defined during feeding the wire (14);
a grinding process (S3) of grinding both sides of the sliced wafer (w) by a grinding wheel, one-side by one-side;
a polishing process of performing a chemical mechanical polishing on both sides of the ground wafer by a fixed abrasive grain polishing cloth, in which an abrasive grain is fixed, and an abrasive containing no abrasive grains.

2. The method for manufacturing the semiconductor wafers according to claim 1, further comprising the steps of:
an etching process (S4) of removing a deformed layer of the wafer generated by the grinding process (S3);
a mirror beveling process (S5) of finishing an outer peripheral edge of the wafer as a mirror; and
a single side finish polishing process (S7) of finishing one side of the wafer as a mirror after the polishing process.

3. The method for manufacturing the semiconductor wafers according to claim 1, wherein the fixed abrasive grain polishing cloth is a polyurethane polishing pad comprising:
a polyfunctional isocyanate;
a polyfunctional polyol having an average molecular weight of 250 or more and 4,000 or less;
a foaming agent for setting an expansion ratio of the polishing pad as 1.11 to 5 times; and
abrasive grains having an average diameter of 0.15 µm or more and 50 µm or less in a range of 5 vol.% or more and 70 vol.% or less,
wherein the abrasive grains are mixed with the stirred mixture of the polyfunctional isocyanate, polyfunctional polyol and foaming agent.

4. A slicing method for slicing a work by using a wire saw (1) comprising a wire array formed by winding a wire (14) multiple times around a plurality of processing rollers (11,12,13), the slicing method comprising the steps of:
reciprocatingly feeding the wire (14) at predetermined constant cycles of 3 or more and less than 8 per a minute, the one reciprocation of the wire (14) being determined as one cycle;
supplying slurry between the wire array and the work (W); and
pushing the work (W) onto the wire array so as to slice the work (W) into a plurality of wafers at one time,
**characterized in that** the wire (14) is fed such that a returning length, of which length is defined during returning the wire (14), is shorter than a going length, of which length is defined during feeding the wire (14).

5. A wire saw, comprising:
a wire (14);
a releasing reel for releasing the wire (14);
a winding reel for winding the wire (14);
a pair of reel motors (19,20) for rotating the releasing reel and the winding reel; a wire array formed by winding the wire (14) multiple times among processing rollers (11,12,13), which are arranged to be parallel to each other at an intermediate portion between the releasing reel and the winding reel, and
a spindle motor (18) applying rotary force in forward or reverse directions to the processing roller to thereby reciprocate the wire (14),
wherein the wire saw (1) slices a work (W) into a plurality of wafers (w) at one time by pushing the work (W) onto the wire array while feeding the wire (14) and supplying a slurry between the wire array and the work (W), and wherein the wire saw (1) further comprises a wire (14) feeding control unit which controls the spindle motor (18) and the pair of reel motors (19,20) such that:
the wire (14) is reciprocated in a predetermined constant cycle of 3 or more and less than 8 per a minute, one reciprocation of the wire (14) being determined as one cycle in the slicing process (51); and the same cycle pattern is repeated with respect to the same work (W) at maximum speed of the wire (14) for one cycle ranging from 600 m/min or more and 1500 m/min or less,
**characterized in that** the wire feeding control unit further controls the spindle motor (18) and the pair of reel motors (19, 20) such that a returning length, of which length is defined during returning the wire (14), is shorter than a going length, of which length is defined during feeding the wire (14), and
the spindle motor (18) has an output capacity of 45 kW or more and 110 kW or less.

## Patentansprüche

1. Verfahren zum Herstellen von Halbleiter-Wafern, das die folgenden Schritte umfasst:
einen Sägevorgang (S1) zum Zersägen eines Werkstücks (W) unter Verwendung einer Drahtsäge (1), die eine Drahtanordnung umfasst, die ausgebildet wird, indem ein Draht (14) mehrmals um eine Vielzahl von Bearbeitungswalzen (11, 12, 13) herum gewickelt wird, wobei der Sägevorgang die folgenden Schritte umfasst:
Zuführen des Drahtes (14) in Hin- und Herbewegung in vorgegebenen konstanten Zyklen von 3 oder mehr und weniger als 8 pro Minute, wobei eine Hin- und Herbewegung des Drahtes (14) als ein Zyklus festgelegt ist;
Einleiten einer Aufschlämmung zwischen der Drahtanordnung und dem Werkstück (W); und
Schieben des Werkstücks (W) auf die Drahtanordnung, um das Werkstück (W) in einem Vorgang in eine Vielzahl von Wafern zu sägen, **dadurch gekennzeichnet, dass**
der Draht (14) so zugeführt wird, dass eine Rücklauflänge, die als die Länge während des Rücklaufens des Drahtes (14) definiert ist, kürzer ist als eine Vorlauflänge, die als die Länge während des Zuführens des Drahtes (14) definiert ist;
einen Schleifvorgang (S3), in dem beide Seiten des gesägten Wafers (W) Seite für Seite mit einer Schleifscheibe geschliffen werden;
einen Poliervorgang des Durchführens eines chemisch-mechanischen Polierens an beiden Seiten des geschliffenen Wafers mit einem Poliertuch mit fixiertem Schleifkorn, in dem ein Schleikorn fixiert ist, sowie mit einem Schleifmittel, das kein Schleifkorn enthält.

2. Verfahren zum Herstellen der Halbleiter-Wafer nach Anspruch 1, das des Weiteren die folgenden Schritte umfasst:
einen Ätzvorgang (S4) des Entfernens einer verformten Schicht des mit dem Schleifvorgang (S3) erzeugten Wafers;
einen Hochglanz-Anfasvorgang (S5) der Hochglanz-Oberflächenbearbeitung eines äußeren Umfangsrandes des Wafers; und
einen einseitigen Fertigpoliervorgang (S7) des Hochglanz-Oberflächenbearbeitens des Wafers nach dem Poliervorgang.

3. Verfahren zum Herstellen der Halbleiter-Wafer nach Anspruch 1, wobei das Poliertuch mit fixiertem Schleifkorn eine Polyurethan-Polierscheibe ist, die umfasst:
ein polyfunktionales Polyisocyanat;
ein polyfunktionales Polyol mit einem durchschnittlichen Molekulargewicht von 250 oder mehr und 4000 oder weniger;
ein Aufschäumungsmittel, mit dem ein Ausdehnungsverhältnis der Polierscheibe auf das 1,11- bis 5-fache festgelegt wird; und
Schleifkörner mit einem durchschnittlichen Durchmesser von 0,15 µm oder mehr und 50 µm oder weniger in einem Bereich von 5 Vol.-% oder mehr und 70 Vol.-% oder weniger,
wobei die Schleifkörner mit dem verrührten Gemisch aus dem polyfunktionalen Polyisocyanat, dem polyfunktionalen Polyol und dem Verschäumungsmittel vermischt werden.

4. Sägeverfahren (S1) zum Zersägen eines Werkstücks (W) unter Verwendung einer Drahtsäge (1), die eine Drahtanordnung umfasst, die ausgebildet wird, indem ein Draht (14) mehrmals um eine Vielzahl von Bearbeitungswalzen (11, 12, 13) herum gewickelt wird, wobei das Sägeverfahren die folgenden Schritte umfasst:
Zuführen des Drahtes (14) in Hin- und Herbewegung in vorgegebenen konstanten Zyklen von 3 oder mehr und weniger als 8 pro Minute, wobei eine Hin- und Herbewegung des Drahtes (14) als ein Zyklus festgelegt ist;
Einleiten einer Aufschlämmung zwischen der Drahtanordnung und dem Werkstück (W); und
Schieben des Werkstücks (W) auf die Drahtanordnung, um das Werkstück (W) in einem Vorgang in eine Vielzahl von Wafern zu sägen, **dadurch gekennzeichnet, dass**
der Draht (14) so zugeführt wird, dass eine Rücklauflänge, die als die Länge während des Rücklaufens des Drahtes (14) definiert ist, kürzer ist als eine Vorlauflänge, die als die Länge während des Zuführens des Drahtes (14) definiert ist.

5. Drahtsäge, die umfasst:
einen Draht (14);
eine Abwickelspule zum Abwickeln des Drahtes (14);
eine Aufwickelspule zum Aufwickeln des Drahtes (14);
ein Paar Spulenmotoren (19, 20) zum Drehen der Abwickelspule und der Aufwickelspule;
eine Drahtanordnung, die ausgebildet wird, indem der Draht (14) mehrmals um Bearbeitungswalzen (11, 12, 13) herum gewickelt wird, die in einem Zwischenabschnitt zwischen der Abwickelspule und der Aufwickelspule so angeordnet sind, dass sie parallel zueinander sind; und
einen Spindelmotor (18), der Drehkraft in Vorwärts- oder Rückwärtsrichtung auf die Bearbeitungswalze ausübt, um so den Draht hin- und herzubewegen,
wobei die Drahtsäge (1) ein Werkstück (W) in einem Vorgang in eine Vielzahl von Wafern (W) sägt, indem das Werkstück (W) auf die Drahtanordnung zu geschoben wird und gleichzeitig der Draht (14) zugeführt wird und eine Aufschlämmung zwischen der Drahtanordnung und dem Werkstück (W) eingeleitet wird, und wobei die Drahtsäge (1) des Weiteren eine Einheit zum Steuern des Zuführens eines Drahtes (14) umfasst, die den Spindelmotor (18) und die paarigen Spulenmotoren (19, 20) so steuert, dass der Draht (14) in einem vorgegebenen konstanten Zyklus von 3 oder mehr und weniger als 8 pro Minute hin- und herbewegt wird, wobei eine Hin- und Herbewegung des Drahtes (14) als ein Zyklus bei dem Sägevorgang (51) festgelegt ist und das gleiche Zyklusmuster in Bezug auf das gleiche Werkstück (W) bei maximaler Geschwindigkeit des Drahtes (14) für einen Zyklus wiederholt wird, die von 600 m/min oder mehr bis 1500 m/min oder weniger reicht, **dadurch gekennzeichnet, dass** die Drahtzufuhr-Steuereinheit des Weiteren den Spindelmotor (18) und die paarigen Spulenmotoren (19, 20) so steuert, der Draht (14) so zugeführt wird, dass eine Rücklauflänge, die als die Länge während des Rücklaufens des Drahtes (14) definiert ist, kürzer ist als eine Vorlauflänge, die als die Länge während des Zuführens des Drahtes (14) definiert ist, und
der Spindelmotor (18) eine Ausgangsleistung von 45 kW oder mehr und 110 kW oder weniger hat.

## Revendications

1. Procédé de fabrication de plaquettes semi-conductrices, comprenant les étapes suivantes :
un processus de coupe (S1) destiné à couper une pièce (W) à l'aide d'une scie à fil (1) comprenant un ensemble fil formé par l'enroulement d'un fil (14) de nombreuses fois autour d'une pluralité de rouleaux de traitement (11, 12, 13), le processus de coupe comprenant les étapes consistant à :
charger en va-et-vient le fil (14) selon des cycles constants prédéfinis de 3, ou plus, et de moins de 8 par minute, un mouvement de va-et-vient du fil (14) étant déterminé comme un cycle ;
introduire une suspension entre l'ensemble fil et la pièce (W) ; et
pousser la pièce (W) sur l'ensemble fil de manière à couper la pièce (W) en une pluralité de plaquettes (w) en une fois,
**caractérisé en ce que** le fil (14) est chargé de sorte qu'une longueur de retour, dont la longueur est définie au cours du retour du fil (14), soit plus courte qu'une longueur aller, dont la longueur est définie au cours du chargement du fil (14) ;
un processus de meulage (S3) consistant à meuler les deux côtés de la plaquette coupée (w) à l'aide d'une meule, un côté après l'autre ;
un processus de polissage consistant à réaliser un polissage mécano-chimique sur les deux côtés de la plaquette meulée par un tissu de polissage à grain abrasif fixe, dans lequel un grain abrasif est fixe, et un abrasif ne contenant aucun grain abrasif.

2. Procédé de fabrication de plaquettes semi-conductrices selon la revendication 1, comprenant en outre les étapes consistant à :
un processus de gravure (S4) consistant à retirer une couche déformée de la plaquette produite par le processus de meulage (S3) ;
un processus de biseautage-miroir (S5) consistant à finir un bord périphérique extérieur de la plaquette en tant que miroir ; et
un processus de polissage de finition sur un seul côté (S7) consistant à finir un côté de la plaquette en tant que miroir après le processus de polissage.

3. Procédé de fabrication de plaquettes semi-conductrices selon la revendication 1, dans lequel le tissu de polissage à grain abrasif fixe est un tampon de polissage en polyuréthane comprenant :
un isocyanate polyfonctionnel ;
un polyol polyfonctionnel ayant un poids moléculaire moyen de 250, ou plus, et de 4000 ou moins ;
un agent moussant servant à définir un rapport de dilatation du tampon de polissage de 1,11 à 5 fois ; et
des grains abrasifs ayant un diamètre moyen de 0,15 µm ou plus et de 50 µm ou moins dans une plaque de 5 % en volume ou plus et 70 % en volume ou moins,
dans lequel les grains abrasifs sont mélangés au mélange agité de l'isocyanate polyfonctionnel, du polyol polyfonctionnel et de l'agent moussant.

4. Procédé de coupe destiné à couper une pièce à l'aide d'une scie à fil (1) comprenant un ensemble fil formé par l'enroulement d'un fil (14) de nombreuses fois autour d'une pluralité de rouleaux de traitement (11, 12, 13), le procédé de coupe comprenant les étapes consistant à :
charger en va-et-vient le fil (14) selon des cycles constants prédéfinis de 3, ou plus, et de moins de 8 par minute, un mouvement de va-et-vient du fil (14) étant déterminé comme un cycle ;
introduire une suspension entre l'ensemble fil et la pièce (W) ; et
pousser la pièce (W) sur l'ensemble fil de manière à couper la pièce (W) en une pluralité de plaquettes (w) en une fois,
**caractérisé en ce que** le fil (14) est chargé de sorte qu'une longueur de retour, dont la longueur est définie au cours du retour du fil (14), soit plus courte qu'une longueur aller, dont la longueur est définie au cours du chargement du fil (14).

5. Scie à fil, comprenant :
un fil (14) ;
une bobine de relâchement servant à relâcher le fil (14) ;
une bobine d'enroulement servant à enrouler le fil (14) ;
une paire de moteurs de bobine (19, 20) servant à faire tourner la bobine de relâchement et la bobine d'enroulement ;
un ensemble fil formé par l'enroulement du fil (14) de nombreuses fois entre des rouleaux de traitement (11, 12, 13), qui sont disposés pour être parallèles les uns aux autres au niveau d'une partie intermédiaire entre la bobine de relâchement et la bobine d'enroulement, et
un moteur à axe (18) appliquant une force de rotation vers l'avant ou vers l'arrière sur le rouleau de traitement afin d'animer le fil (14) d'un mouvement de va-et-vient,
dans laquelle la scie à fil (1) coupe une pièce (W) en une pluralité de plaquettes (w) en une fois en poussant la pièce (W) sur l'ensemble fil tout en chargeant le fil (14) et en introduisant une suspension entre l'ensemble fil et la pièce (W), et
la scie à fil (1) comprenant en outre une unité de commande de chargement de fil (14) qui commande le moteur à axe (18) et la paire de moteurs de bobine (19, 20) de sorte que :
le fil (14) soit animé d'un mouvement de va-et-vient dans un cycle constant prédéfini de 3, ou plus et de moins de 8 par minute, un mouvement de va-et-vient du fil (14) étant déterminé comme un cycle dans le processus de coupe (51) ; et le même modèle de cycle est répété par rapport à la même pièce (W) à une vitesse maximale du fil (14) pour un cycle compris entre 600 m/min ou plus et 1500 m/min ou moins,
**caractérisée en ce que** l'unité de commande de chargement de fil commande en outre le moteur à axe (18) et la paire de moteurs de bobine (19, 20) de sorte qu'une longueur de retour, dont la longueur est définie au cours du retour du fil (14), soit plus courte qu'une longueur aller, dont la longueur est définie au cours du chargement du fil (14), et
le moteur à axe (18) a une capacité de sortie de 45 kW ou plus et de 110 kW ou moins.
